# EUROPÄISCHE PATENTSCHRIFT

(11) **EP 1 217 660 B1**
(45) Veröffentlichungstag und Bekanntmachung des Hinweises auf die Patenterteilung: **16.01.2008**
(21) Anmeldenummer: 01128650.7
(22) Anmeldetag: 30.11.2001
(51) Int. Cl.: H01L 23/467

(54) **Kühlvorrichtung**
Cooling device
Dissipateur de chaleur

(30) Priorität: 19.12.2000 DE 10063306
(43) Veröffentlichungstag der Anmeldung: 26.06.2002
(73) Patentinhaber: Fujitsu Siemens Computers GmbH, 80807 München (DE)
(72) Erfinder: Riebel, Michael, 86438 Kissing (DE)
(74) Vertreter: Epping - Hermann - Fischer

(56) Entgegenhaltungen:
- EP-A- 0 760 527
- EP-A- 1 137 064
- US-A- 5 630 469
- US-A- 6 031 720
- PATENT ABSTRACTS OF JAPAN Bd. 1997, Nr. 02, 28. Februar 1997 (1997-02-28) -& JP 08 255855 A (NEC CORP), 1. Oktober 1996 (1996-10-01)
- PATENT ABSTRACTS OF JAPAN Bd. 2000, Nr. 12, 3. Januar 2001 (2001-01-03) -& JP 2000 244162 A (DENSO CORP), 8. September 2000 (2000-09-08)

## Beschreibung

Die Erfindung betrifft eine Kühlvorrichtung für elektronische Bauelemente.

Es ist eine große Vielfalt von Kühlkörpern bekannt. Kleinkühlkörper sind an die genormten Gehäuse von beispielsweise Halbleiterbauelementen angepaßt und können einfach aufgesteckt werden. Zur Verbesserung des Wärmeübergangs zwischen den Halbleiterbauelementen und dem Kühlkörper ist es bekannt, sogenannte Wärmeleitpaste zu verwenden. Für Großkühlkörper werden vorwiegend fertig gezogene Aluminium-Profile benutzt. Verschiedene Ausführungen von Kühlkörpern sind beispielsweise aus "Nührmann, Dieter: Das große Werkbuch Elektronik, Teil A, Franzis-Verlag, München 1998" bekannt.

Bei Mikroprozessoren hängt die erzeugte Wärme in hohem Maß von der verwendeten Taktfrequenz ab. Je höher die Taktfrequenz ist, desto größer ist die Verlustleistung und damit die Wärme, die an die Umgebung abgeführt werden muß. Durch Fortschritte in der Halbleitertechnologie ist die Taktfrequenz mittlerweile so hoch, daß bisher bekannte Kühlkörper in der üblichen Größe nicht mehr ausreichen, selbst wenn Lüfter zur Zwangskühlung eingesetzt werden. Die einzige Möglichkeit, dennoch eine ausreichende Kühlung sicherzustellen, ist daher die Kühlkörper weiter zu vergrößern, was aber aus anderen konstruktiven und technischen Gründen nicht wünschenswert oder nicht möglich ist.

Prinzipiell ist es bekannt, einen Lüfter direkt auf einen Kühlkörper aufzusetzen, wodurch eine erhöhte Wärmeabgabefähigkeit des Kühlkörpers erreicht wird. Problematisch dabei ist, daß die austretende Luft durch Störkonturen der Kühlrippen verwirbelt wird und nicht im gewünschten Maß die Kühlung verbessert. Ein Großteil der Strömungsenergie wird durch die Verwirbelungen vernichtet und beispielsweise in Schall umgewandelt, was zu einer unerwünschten Geräuschentstehung führt.

Aus dem Dokument PATENT ABSTRACTS OF JAPAN Bd. 1998, Nur. 11, 30.September 1998 (1998-09-30)-& JP 101548889 A (YASKAWA ELEC-TRIC CORP), 9. Juni 1998 (1998-06-09) ist eine Kühlvorrichtung bekannt, bei der die Fläche der wäremabstrahlenden Kühlrippen als effektive wärmeleitende Fläche wirkt, indem ein Luftstrom mit hoher Geschwindigkeit von einem Lüfter zu den Kühlrippen geleitet wird. Die Kühlvorrichtung besteht aus einer Basisplatte mit wärmeabstrahlenden Kühlrippen und wird mit einem zu kühlenden Bauteil in Berührung gebracht. Auf den Kühlrippen ist eine Strömungsleitvorrichtung angeordnet, deren Grundplatte im Inneren ein Loch aufweist, und ein Leitblech um das Loch spiralförmig angeordnet ist, so dass der Luftstrom von einem über der Strömungsleitvorrichtung angeordneten Lüfters durch das Loch hindurch und auf die Kühlrippen geleitet wird.

Aus dem Dokument PATENT ABSTRACTS OF JAPAN Bd. 1997, Nr. 10, 31. Oktober 1997 (1997-10-31) -& JP 09 153573 A (YASKAWA E-LECTRIC CORP), 10. Juni 1997 (1997-06-10) ist ein Kühlkörper bekannt der aus nadelförmigen Kühlrippen besteht. Am Rand des Kühlkörpers ist einer Höhe, die mindestens ein Drittel der Höhe einer Kühlrippe ist, eine Aluminiumfolie um den Kühlkörper gewickelt. Die kühlende Luft eines über dem Kühlkörper angeordneten Lüfters fließt an den oberen Spitzen der nadelförmigen Kühlrippen vorbei und verlässt den Kühlkörper im unteren Teil, der nicht durch die Aluminiumfolie umwickelt ist, nach außen.

Die Aufgabe der vorliegenden Erfindung ist es, eine Kühlvorrichtung anzugeben, durch die eine gute Kühlung mit geringem Aufwand erreicht wird. Die Abmessungen der Kühlvorrichtung sollen dabei möglichst klein sein.

Diese Aufgabe wird durch eine Kühlvorrichtung gelöst mit einer Basisplatte, die mit einem zu kühlenden Bauteil in Kontakt bringbar ist, einem Lüfter und einer Strömungsleitvorrichtung, die durch eine Anordnung aus Leitblechabschnitten gebildet ist, und die einen durch den Lüfter erzeugten Luftstrom auf die Basisplatte lenkt und direkt wärmeleitend mit der Basisplatte verbunden ist, wobei in den Leitblechabschnitten im Verbindungsbereich zwischen denLeitblechabschnitten und der Basisplatte Ausnehmungen zur Bildung von Luftkanälen vorgesehen sind, durch die der Luftstrom seitlich entweichen kann.

Die Leitblechabschnitte erfüllen eine doppelte Funktion. Zum einen lenken sie die durch den Lüfter erzeugte Luftströmung optimiert auf die zu kühlenden Bereiche, zum anderen sind die Leitblechabschnitte ebenfalls wärmeleitfähig, so daß sie die Funktion von Kühlrippen übernehmen. Durch die erfindungsgemäße Ausgestaltung der Leitblechabschnitte wird die Luft ohne große Verwirbelungen in einem Strömungskanal bis zu der Bäsisplatte geführt, wobei die Basisplatte die heißeste Stelle der Kühlvorrichtung darstellt. Die von oben eingeblasene Luft erfährt dort eine Umlenkung um 90°. Die Luft wird anschließend durch die Luftkanäle abgeführt. Eine Verwirbelung findet erst an dieser Stelle statt, was wesentlich wirkungsvoller ist als eine Verwirbelung im Bereich von Kühlrippen nach dem Stand der Technik. In einer vorteilhaften Ausgestaltung der Erfindung sind die Leitblechabschnitte durch ein spiralförmig gebogenes Leitblech gebildet, das senkrecht auf der Basisplatte steht. Um den Lufteintritt in den oder die spiralförmigen Strömungskanäle zu erleichtern ist es von Vorteil, wenn die Höhe der Leitblechabschnitte im Zentrum der Kühlvorrichtung geringer ist als nach außen hin.

Ein zusätzlicher Vorteil ergibt sich, wenn die Dicke der Leitblechabschnitte ausgehend von der Basisplatte abnehmend ist. In Richtung der Luftbewegung verengt sich dadurch der Querschnitt des oder der Strömungskanäle, was zu einer Strömungsbeschleunigung und damit zu einer besonders guten Kühlleistung führt.

Weitere vorteilhafte Ausgestaltungen sind in den Unteransprüchen angegeben.

Die Erfindung wird nachfolgend anhand von Ausführungsbeispielen näher beschrieben. Es zeigt:
- Figur 1: eine erfindungsgemäße Kühlvorrichtung in einer Seitenansicht,
- Figur 2: die Kühlvorrichtung von Figur 1 in einer Draufsicht,
- Figur 3: eine Abwicklung der Kühlblechabschnitte der Kühlvorrichtung von Figur 1 und 2,
- Figur 4: einen Querschnitt durch einen Leitblechabschnitt,
- Figur 5: ein zweites Ausführungsbeispiel einer erfindungsgemäßen Kühlvorrichtung in einer Draufsicht,
- Figur 6: ein drittes Ausführungsbeispiel einer erfindungsgemäßen Kühlvorrichtung in einer Draufsicht und
- Figur 7: ein viertes Ausführungsbeispiel einer erfindungsgemäßen Kühlvorrichtung in einer Seitenansicht.

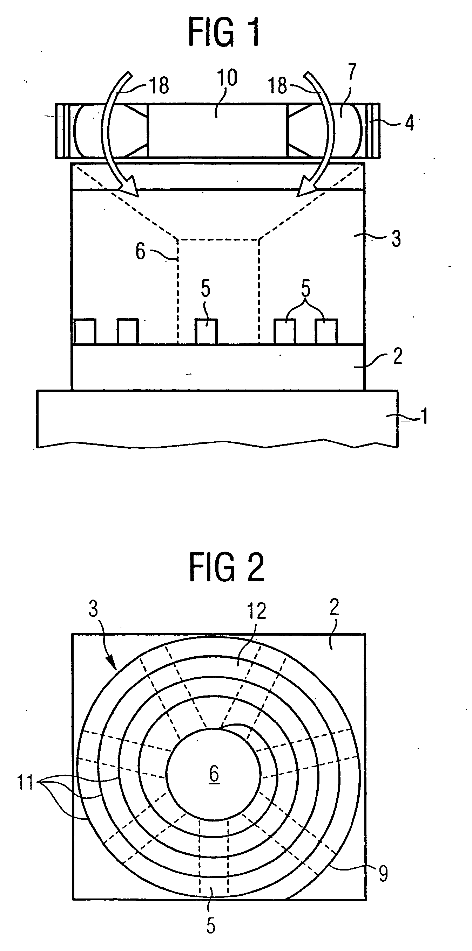

In der Figur 1 ist eine Kühlvorrichtung gemäß der Erfindung dargestellt, die auf einem zu kühlenden Bauteil 1 befestigt ist. Auf der Basisplatte 2 ist eine Strömungsleitvorrichtung 3 befestigt. Sowohl die Basisplatte 2 als auch die Strömungsleitvorrichtung 3 sind aus einem thermisch gut leitenden Material gefertigt. Besonders gut geeignet sind Kupfer- und Aluminiumwerkstoffe. Die Strömungsleitvorrichtung 3 ist mit der Basisplatte 2 so verbunden, daß ein guter Wärmeübergang von der Basisplatte 2 auf die Strömungsleitvorrichtung 3 sichergestellt ist. Auf die Strömungsleitvorrichtung 3 ist ein Lüfter 4 mit einer Lüfternabe 10 und Lüfterflügeln 7 aufgesetzt. Durch den Lüfter 4 wird ein Luftstrom 6 erzeugt, der von oben in die Strömungsleitvorrichtung 3 eintritt und diese durch Luftkanäle 5 wieder verläßt.

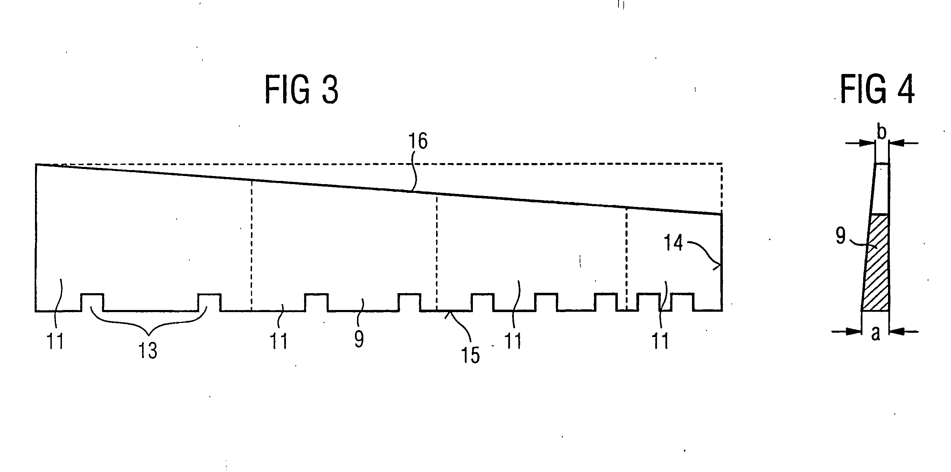

Figur 2 zeigt die Draufsicht auf die Kühlvorrichtung von Figur 1. In dieser Darstellung ist gut zu erkennen, welche Form die Strömungsleitvorrichtung 3 besitzt. Sie ist durch eine Anordnung aus Leitblechabschnitten 11 gebildet. Dadurch entsteht ein Strömungskanal, der die von dem Lüfter 4 eingeblasene Luft in definierten Bahnen lenkt. In dem Ausführungsbeispiel von Figur 2 ist durch die Leitblechabschnitte 11 ein spiralförmiger Strömungskanal 12 gebildet. Die Orientierung der spiralförmigen Wicklung entspricht dem Drall der von dem Lüfter 4 eingeblasenen Luftströmung 6. Insgesamt bilden die Leitblechabschnitte 11 ein einstückiges Leitblech 9, das abgewickelt in Figur 3 dargestellt ist. Im Zentrum der spiralförmigen Wicklung befindet sich ein massiver Kern 6. Die von dem zu kühlenden Bauteil 1 auf die Basisplatte 2 übertragene Wärme wird in der Basisplatte 2 verteilt und sowohl auf den massiven Kern 6 als auch auf die Leitblechabschnitte 11 übertragen. Damit ist eine optimale Wärmeverteilung und eine optimale Wärmeaufnahmefähigkeit der Kühlvorrichtung gewährleistet.

Wegen der Doppelfunktion der Leitblechabschnitte 11 zur Strömungsleitung und zur Wärmeabgabe ist es wichtig, daß die Verbindung zwischen den Leitblechabschnitten 11 und der Basisplatte 2 wärmeleitend erfolgt. Die günstigste Leitfähigkeite besitzt eine Lötverbindung, aber auch eine Verbindung mit einem wärmeleitfähigen Kleber ist denkbar. Die von oben in die Strömungsleitvorrichtung 3 eingeblasene Luft wird durch Luftkanäle 5, die auf der Oberfläche der Basisplatte 2 verlaufen, wieder abgeführt. Die Luftkanäle 5 werden in einfacher Weise dadurch realisiert, daß in dem Leitblech 9 Ausstanzungen 13 vorgesehen sind, wobei deren Anordnung so erfolgt, daß sich im auf der Basisplatte 2 befestigten Zustand eine sternförmige Anordnung der Luftkanäle 5 ergibt.

Die Herstellung einer erfindungsgemäßen Kühlvorrichtung kann so erfolgen, daß eine Kupferfolie um einen massiven Kupferkern gewickelt wird. Die Kupferfolie bildet die Leitblechabschnitte 11. Die Kupferfolie ist über ihre Höhe idealerweise unterschiedlich dick, beispielsweise zwischen 0,2 mm und 0,5 mm. Der Vorteil, der sich hierdurch ergibt, ist in einem der folgenden Abschnitte beschrieben. Die zunächst eng gewikkelte Folie dreht sich durch Entlastung nach dem Wickeln teilweise leicht wieder auf. Dieser Vorgang ist gewollt und muß im vorbestimmten Maße geschehen. Um dieses in zulässigen Toleranzen sicherzustellen, muß das Material und die Eindrehkraft genau definiert werden. Die somit entstandene Spirale wird anschließend auf die Basisplatte 2 gelötet, die vorteilhafterweise ca. 5 mm dick ist.

Die in Figur 3 dargestellte Abwicklung des Leitblechs 9 ist im wesentlichen trapezförmig. An einer ersten Seitenkante 14 wird die Abwicklung an dem massiven Kern 6 befestigt. Dadurch ergibt sich im fertig montierten Zustand eine Strömungsleitvorrichtung, bei der die Höhe der innen liegenden Leitblechabschnitte geringer ist als die Höhe der außen liegenden Leitblechabschnitte. Die Materialdicke des Leitblechs 9 nimmt ausgehend von der unteren Kante 15 bis zur oberen Kante 16 ab, wie in Figur 4 dargestellt ist. In einer günstigen Ausführung beträgt die Dicke des Leitblechs an der Kante 15 ungefähr a = 0,5 mm und an der oberen Kante 16 b = 0,2 mm. Dies trägt sowohl der Wärmeleitfunktion als auch der Strömungsleitfunktion Rechnung. Bezüglich der Wärmeleitfunktion nimmt der Wärmestrom von der Kante 15 zur Kante 16 hin ab. Dies resultiert einfach daraus, daß Wärme an die Umgebung abgegeben wird. Bei einer nach oben hin abnehmenden Leitblechdicke bleibt die Wärmestromdichte daher gleich. Bezüglich der Strömungsleitfunktion ergibt sich durch diese Ausgestaltung der Leitblechdicke ein nach unten, also zur Basisplatte 2 hin abnehmender Strömungskanalquerschnitt. Dies führt zu einer Beschleunigung der Strömungsbewegung zur Basisplatte 2 hin, was den Wärmeübergang von der Basisplatte 2 bzw. den Leitblechabschnitten 11 in diesem Bereich verbessert. An der Basisplatte 2 angekommen, wird die Luft um 90° abgelenkt und verläßt die Kühlvorrichtung durch die Luftkanäle 5.

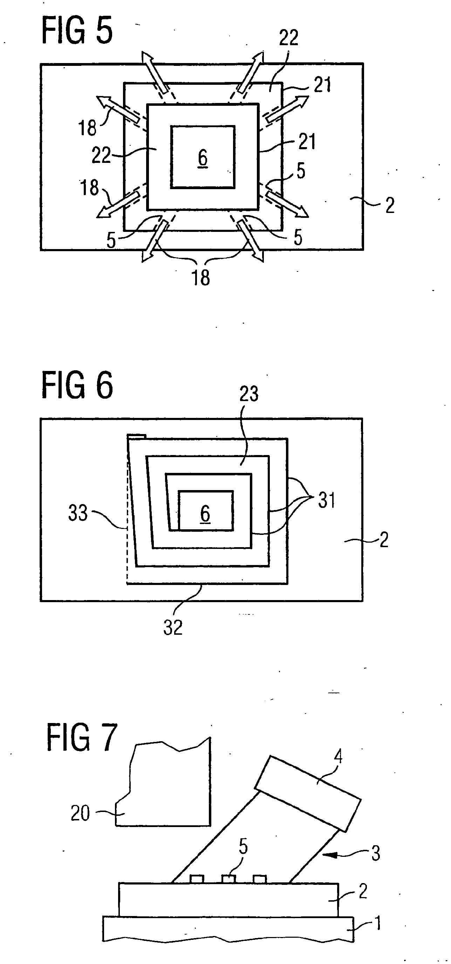

Die in den Figuren 5, 6 und 7 dargestellten Ausführungsbeispiele zeigen weitere Realisierungsmöglichkeiten erfindungsgemäßer Kühlvorrichtungen. Im Ausführungsbeispiel von der Figur 5 sind Leitblechabschnitte 21 nicht durch ein einstückiges Leitblech gebildet, wie dies im Fall des Ausführungsbeispiels von Figur 2 der Fall ist, sondern es werden separate Leitbleche verwendet, so daß sich mehrere Strömungskanäle 22 bilden. Zwar kann in einer solchen Ausführung die Luft nur noch bedingt zirkulieren, also sich in einer Rotationsbewegung nur noch innerhalb eines Strömungskanals 22 bewegen, allerdings können die Luftkanäle 5 entsprechend dimensioniert werden, so daß ausreichende Möglichkeit zur Abführung der Luftströmung 18 vorhanden ist.

Im Ausführungsbeispiel von der Figur 6 sind Leitblechabschnitte 31 wiederum einstückig durch ein Leitblech 32 gebildet. Dadurch ergibt sich, wie im Ausführungsbeispiel von Figur 2, ein spiralförmiger Strömungskanal 23, wobei die Leitblechabschnitte 31 abschnittsweise gerade sind. Ein Abschnitt 33 des äußersten Leitblechabschnitts ist so ausgestaltet, daß sich nahe der Basisplatte 2 eine ausreichend große Öffnungen ergibt, um die sich durch die Spirale in einer Drehung befindliche Luft abzuführen. Im oberen Bereich dieses Abschnitts 33, was allerdings in der Figur nicht zu erkennen ist, ist keine Öffnung mehr vorhanden, um eine formschlüssige Verbindung zu einem Lüfter 4 möglich zu machen.

In den Ausführungsbeispielen der Figuren 2, 5 und 6 sind die Leitblechabschnitte 11, 21 bzw. 31 senkrecht auf der Basisplatte 2 angeordnet. In der Figur 7 ist ein Ausführungsbeispiel gezeigt, in dem dies nicht der Fall ist, beispielsweise um den Einbau weiterer Systemkomponenten von den Platzgründen her zu ermöglichen.

In der Beschreibung der Ausführungsbeispiele wurde der Begriff Leitblech verwendet. Dieser ist auch so zu verstehen, daß es sich beispielsweise um eine Folie oder eine Gußteil handeln kann. Die erfindungsgemäße Funktion wird dennoch erfüllt.

## Patentansprüche

1. Kühlvorrichtung mit
- einer Basisplatte (2), die mit einem zu kühlenden Bauteil (1) in Kontakt bringbar ist,
- einem Lüfter (4), der oberhalb der Basisplatte (2) und von dieser beabstandet angeordnet ist, und
- einer zwischen der Basisplatte (2) und dem Lüfter (4) angeordneten Strömungsleitvorrichtung (3), die
- durch eine Anordnung aus Leitblechabschnitten (11; 21; 31) gebildet ist,
- einen durch den Lüfter (4) erzeugten Luftstrom (18) auf die Basisplatte (2) lenkt
- direkt wärmeleitend mit der Basisplatte (2) verbunden ist,
**dadurch gekennzeichnet, dass**
in einem von der Basisplatte (2) beabstandeten Bereich durch die Leitblechabschnitte (11; 21; 31) ein seitlich geschlossener Kanal gebildet ist und in den Leitblechabschnitten (11; 21; 31) im Verbindungsbereich zwischen den Leitblechabschnitten (11; 21; 31) und der Basisplatte (2) Ausnehmungen (13) zur Bildung von Luftkanälen (5) vorgesehen sind, durch die der Luftstrom seitlich entweichen kann.

2. Kühlvorrichtung nach Anspruch 1,
**dadurch gekennzeichnet, daß**
die Leitblechabschnitte (11; 21; 31) auf der Basisplatte (2) senkrecht stehen.

3. Kühlvorrichtung nach Anspruch 1,
**dadurch gekennzeichnet, daß**
die Leitblechabschnitte (11) durch ein spiralförmig gebogenes Leitblech (9) gebildet sind.

4. Kühlvorrichtung nach Anspruch 1,
**dadurch gekennzeichnet, daß**
die Leitblechabschnitte (21) einzelne Leitbleche sind.

5. Kühlvorrichtung nach Anspruch 3,
**dadurch gekennzeichnet, daß**
die Höhe des Leitblechs von innen nach außen zunimmt.

6. Kühlvorrichtung nach Anspruch 1,
**dadurch gekennzeichnet, daß**
die Höhe von innen liegenden Leitblechabschnitten geringer ist als die Höhe von außen liegenden Leitblechabschnitten.

7. Kühlvorrichtung nach Anspruch 1,
**dadurch gekennzeichnet, daß**
die Dicke der Leitblechabschnitte ausgehend von der Basisplatte (2) abnimmt.

8. Kühlvorrichtung nach einem der Ansprüche 1 bis 7,
**dadurch gekennzeichnet, daß**
der Lüfter (4) formschlüssig mit dem äußersten Leitblechabschnitt verbunden ist.

9. Kühlvorrichtung nach einem der Ansprüche 1 bis 8,
**dadurch gekennzeichnet, daß**
die Strömungsleitvorrichtung (3) einen massiven Kern (6) besitzt, der wärmeleitend mit der Basisplatte (2) und den Leitblechabschnitten (11;31) verbunden ist.

## Claims

1. Cooling device having
- a baseplate (2), which can be brought into contact with a component (1) to be cooled,
- a fan (4), which is arranged above the baseplate (2) and at a distance therefrom, and
- a flow baffle device (3) arranged between the baseplate (2) and the fan (4), which
- is formed by an arrangement of baffle plate sections (11; 21; 31),
- directs an airflow (18) created by the fan (4) onto the baseplate (2),
- is directly connected to the baseplate (2) in a thermally conductive manner,
**characterized in that** a laterally closed channel is formed by the baffle plate sections (11; 21; 31) in a region at a distance from the baseplate (2), and cutouts (13) for forming air channels (5) are provided in the baffle plate sections (11; 21; 31) in the connecting area between the baffle plate sections (11; 21; 31) and the baseplate (2), through which channels the airflow can escape laterally.

2. Cooling device according to Claim 1, **characterized in that** the baffle plate sections (11; 21; 31) are perpendicular to the baseplate (2).

3. Cooling device according to Claim 1, **characterized in that** the baffle plate sections (11) are formed by a spirally shaped baffle plate (9).

4. Cooling device according to Claim 1, **characterized in that** the baffle plate sections (21) are individual baffle plates.

5. Cooling device according to Claim 3, **characterized in that** the height of the baffle plate increases from the inside to the outside.

6. Cooling device according to Claim 1, **characterized in that** the height of inner baffle plate sections is lower than the height of outer baffle plate sections.

7. Cooling device according to Claim 1, **characterized in that** the thickness of the baffle plate sections decreases starting from the baseplate (2).

8. Cooling device according to one of Claims 1 to 7, **characterized in that** the fan (4) is positively connected to the outermost baffle plate section.

9. Cooling device according to one of Claims 1 to 8, **characterized in that** the flow baffle device (3) has a solid core (6), which is connected in a thermally conductive manner to the baseplate (2) and the baffle plate sections (11; 31).

## Revendications

1. Dispositif de refroidissement avec
- une plaque de base (2) qui peut être amenée en contact avec un composant (1) à refroidir,
- un ventilateur (4) qui est disposé au-dessus de la plaque de base (2) et à distance de celle-ci, et
- un dispositif (3) de guidage de flux, disposé entre la plaque de base (2) et le ventilateur (4), qui
- est formé par un ensemble de segments (11 ; 21 ; 31) de tôle de guidage,
- dirige sur la plaque de base (2) un flux d'air (18) produit par le ventilateur (4),
- est directement relié en conduction thermique à la plaque de base (2),
**caractérisé en ce qu'**un canal latéralement fermé est formé par les segments (11; 21; 31) de tôle de guidage dans une région distante de la plaque de base (2), et des évidements (13) sont prévus dans les segments (11 ; 21 ; 31) de tôle de guidage dans la région de liaison entre les segments (11 ; 21 ; 31) de tôle de guidage et la plaque de base (2), afin de former des canaux d'air (5) par lesquels le flux d'air peut s'échapper latéralement.

2. Dispositif de refroidissement selon la revendication 1, **caractérisé en ce que** les segments (11 ; 21 ; 31) de tôle de guidage se dressent verticalement sur la plaque de base (2).

3. Dispositif de refroidissement selon la revendication 1, **caractérisé en ce que** les segments (11) de tôle de guidage sont formés par une tôle de guidage (9) courbée en spirale.

4. Dispositif de refroidissement selon la revendication 1, **caractérisé en ce que** les segments (21) de tôle de guidage sont des tôles de guidage individuelles.

5. Dispositif de refroidissement selon la revendication 3, **caractérisé en ce que** la hauteur de la tôle de guidage augmente de l'intérieur vers l'extérieur.

6. Dispositif de refroidissement selon la revendication 1, **caractérisé en ce que** la hauteur des segments de tôle de guidage situés à l'intérieur est inférieure à la hauteur des segments de tôle de guidage situés à l'extérieur.

7. Dispositif de refroidissement selon la revendication 1, **caractérisé en ce que** l'épaisseur des segments de tôle de guidage diminue en partant de la plaque de base (2).

8. Dispositif de refroidissement selon l'une quelconque des revendications 1 à 7, **caractérisé en ce que** le ventilateur (4) est relié en engagement positif au segment de tôle de guidage le plus extérieur.

9. Dispositif de refroidissement selon l'une quelconque des revendications 1 à 8, **caractérisé en ce que** le dispositif (3) de guidage de flux possède un noyau massif (6) qui est reliée en conduction thermique à la plaque de base (2) et aux segments (11 ; 31) de tôle de guidage.
